# EUROPEAN PATENT APPLICATION

(11) **EP 1 246 265 A2**
(43) Date of publication of application: **02.10.2002**
(21) Application number: 02007028.0
(22) Date of filing: 27.03.2002
(51) Int. Cl.: H01L 33/00

(54) **Light emitting device**

(30) Priority: 30.03.2001 JP 2001097844
(71) Applicant: SUMITOMO ELECTRIC INDUSTRIES, LTD., Osaka-shi, Osaka (JP); Rohm Co., Ltd., Kyoto-shi Kyoto (JP)
(72) Inventor: Matsubara, Hideki, 1-chome, Konohana-ku, Osaka-shi, Osaka (JP); Takebe, Toshihiko, 1-1, Koyakita 1-chome, Itami-shi, Hyogo (JP); Ishinaga, Hiroki, Kyoto-shi, Kyoto (JP); Maegawa, Mamoru, Kyoto-shi, Kyoto (JP)
(74) Representative: Grünecker, Kinkeldey, Stockmair & Schwanhäusser Anwaltssozietät

(57) **Abstract**

The present invention provides a light emitting device including: a resin base (3) having a patterned interconnection (4); an n-type ZnSe substrate mounted on the resin base (3); an epitaxial light emission structure formed of a compound crystal relating ZnSe serving as a matrix, formed on the ZnSe substrate and emitting light when an electric current is introduced thereinto; and a reflector (8) allowing a spatial distribution in intensity of fluorescence to be approximate to that in intensity of light emission from the epitaxial light emission structure, the fluorescence being obtained in the ZnSe substrate excited with the light emission from the epitaxial light emission structure.

## Description

### BACKGROUND OF THE INVENTION

### Field of the Invention

The present invention relates generally to light emitting devices in the form of a single semiconductor chip and capable of emitting light of white color, neutral colors between red and blue, i.e., magenta or pink and the like, and particularly to structures improving a spatial distribution of a color of light emitted thereby.

### Description of the Background Art

As a material for a high bright light emitting diode (LED) a device including a light emitting layer of AlGaAs, GaAsP and the like for red color has been put to practical use and an intensity of no less than several candela (Cd) has been implemented by an inexpensive LED. Other than LEDs for red, GaP for green and yellow-green, GaInN for blue and green, AlGaInP for Mars yellow and yellow have all been put to practical use as inexpensive LEDs.

These LEDs, however, all use a single semiconductor material for their light emitting layers and in principle they can only provide monochromatic light emission. Thus, while typical LEDs are capable of emitting light of a primary color, a color between red and green, and a color between green and blue, such as red, Mars yellow, yellow, yellow-green, green, blue-green, blue, blue-violet and violet, they are incapable of emitting light of a neutral color between red and blue and a neutral color between red, green and blue.

For illumination, decoration and some other similar applications for displaying, a source of light of a color between red and blue (e.g., magenta, pink), a color between red, blue and green (i.e., white), or the like is demanded, rather than a source of monochromatic light as described above. As has been described above, typical LEDs can only achieve a source of monochromatic light, and thus for their source of light a fluorescent lump, an incandescent lump or the like is used and it has thus suffered short lifetime, large sizes and low luminosity.

In contrast, the present inventors have succeeded in obtaining white light, pink light, magenta light and the like from a single LED using a ZnSe-based homoepitaxial layer formed on a ZnSe substrate, as has been described in Japanese Patent Laying-Open Nos. 2000-82845 and 2000-150960.

A ZnSe substrate which is doped with iodine, aluminum, chlorine, bromine, gallium, indium or the like can provide conductance of n-type, and when it is illuminated with light of shorter than 510 nm, ZnSe can provide a so-called self-activated (SA) luminescence, a broad light emission having a center of an emission wavelength in a range of 550 nm to 650 nm. This light emission appears to be yellow, Mars yellow, or the like.

The central wavelength and the half-width of emission spectrum of SA luminescence can be adjusted by the species, amount or the like of the dopant introduced. Furthermore, a light emission structure of ZnSe used as a matrix can be formed on a ZnSe substrate through homoepitaxy. In this light emission structure, ZnSe or ZnCdSe or ZnSeTe can be used for an active layer to form a high bright LED emitting light at a wavelength from 460 nm to 510 nm for blue color or blue-green color.

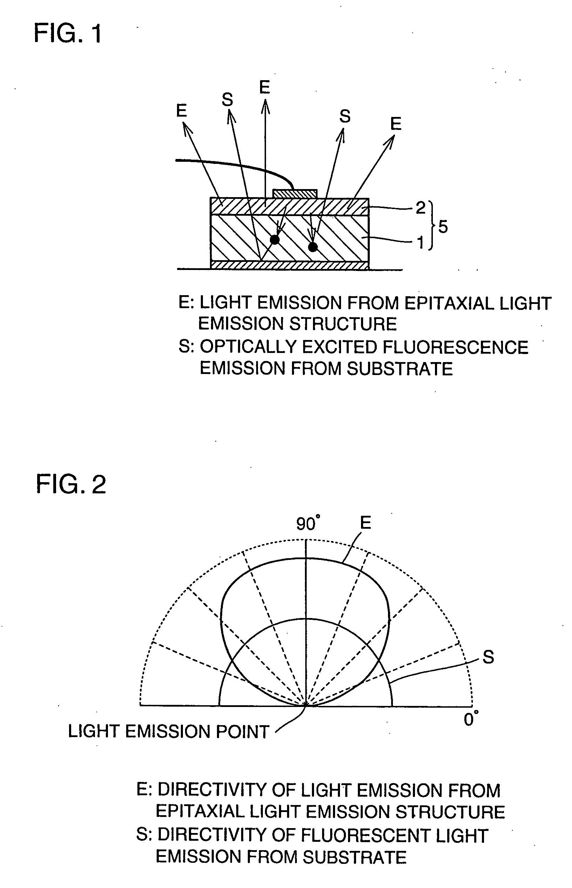

Fig. 1 shows a concept of the present LED, In the figure an epitaxial light emission structure provides blue or blue-green light emission, of which that emitted toward the substrate is absorbed by a ZnSe substrate 1 and excites optically SA light emission and thus provides yellow, Mars yellow or red light. The former light emission and the latter light emission can be combined together to obtain emission of light of white, pink, magenta or other similar neutral colors.

In the present LED, however, the emitting point and the spatial distribution of the blue or blue-green emission at the epitaxial light emission structure are different from those of the yellow or Mars yellow light emission (that is, fluorescence) at the ZnSe substrate. Thus depending on the direction of the light radiating from the LED the former light emission and the latter light emission are mixed at different ratios and the resultant light emission varies in color disadvantageously.

So a particular improvement is required to also adjust the ratio in intensity between the former light and the latter light to adjust the color of the light emitted from the LED. These issues are not limited to ZnSe-based LEDs for white color and they are common to ZnSe-based LEDs for pink, magenta and other similar neutral colors, and any multi-color LEDs having a substrate which emitting light by fluorescence comprised of other materials than ZnSe.

These issues can be addressed, as described in Japanese Patent Laying-Open No. 2000-82845 for example by fixing the epitaxial light emission structure down to a stem (epi-side down configuration) which is a frame of the device, to allow light to be radiated through the substrate. Another solution example is composed of entirely covering around the device with ZnSe substrate 1.

These approaches, however, contribute to increased cost and disadvantageously prevent typical LED production lines from being used as they are.

The present LED is also be expected to be applied to displaying in mobile gear, such as a back light of a color liquid crystal display of a cellular phone, an illumination positioned under a key-button thereof, and the like significantly marketably.

These applications, however, require that a form of a significantly miniaturized surface-mounted LED be implemented at low cost, which is also a significant issue to be addressed,

### SUMMARY OF THE INVENTION

The present invention has been made to address the above issues. The present invention contemplates a light emitting device provided by a simple and inexpensive process, and emitting light of white, and magenta, pink and other similar neutral colors having a spatially uniform color distribution and provided in various color tones.

The present light emitting device includes: a base having an electrode; a substrate formed of n-type ZnSe single crystal and mounted on the base; an epitaxial light emission structure comprised of a compound crystal relating ZnSe serving as a matrix thereof, the epitaxial light emission structure being provided on the substrate and emitting light when an electric current introduced thereinto; and a reflector correcting the difference in spatial distribution in intensity of light emission between the emitting light from the epitaxial structure and the fluorescence light from the substrate.

The reflector scatters the fluorescence from the substrate in a direction of light emitted by the epitaxial light emitting structure. Furthermore the reflector is provided on the base located around the substrate.

Preferably the reflector has an optical reflectance varying to adjust a ratio in intensity between the light emission from the epitaxial light emission structure and the fluorescence from the substrate. Two colors of light can thus be mixed at a ratio varying to obtain a mixture of colors in an aimed color tone as desired.

The reflector includes resin of white color, resin having a light scattering medium buried therein, and resin having a surface covered with film of metal, and the base includes a printed circuit board formed of resin and having a patterned interconnection.

The present light emitting device emits light of white color ranging from yellowish white color through bluish white color, or a neutral color including magenta, pink and the like.

The foregoing and other objects, features, aspects and advantages of the present invention will become more apparent from the following detailed description of the present invention when taken in conjunction with the accompanying drawings.

### BRIEF DESCRIPTION OF THE DRAWINGS

In the drawings:
Fig. 1 is a cross section of a multi-color LED having a substrate emitting light;
Fig. 2 represents a spatial distribution (E) in intensity of light emission from an epitaxial light emission structure in a bare chip of a multi-color LED having a substrate emitting light, and a spatial distribution (S) in intensity of fluorescence of the substrate;
Fig. 3 is a cross section of an example of a structure of a surface-mounted LED sealed with transparent resin;
Fig. 4A shows a reflector of the present invention and Fig. 4B represents a directivity of fluorescence of a substrate with and without the reflector of Fig. 4A, and Fig. 4C shows a conventional reflector and Fig. 4D represents a directivity of fluorescence of a substrate with and without the reflector of Fig. 4C;
Fig. 5 is chromaticity coordinates (X, Y) representing a color of light emitted by an epitaxial light emission structure and a color of fluorescence of a substrate;
Fig. 6 is a cross section of a ZnSe substrate and epitaxial light emission structure of a LED of the present invention in a first embodiment;
Figs. 7A-7D are cross sections of LEDs in the first embodiment;
Figs. 8A-8D each represent a spatial distribution in intensity of light emission of an epitaxial light emission structure and that in intensity of fluorescence of a substrate in a respective one of the Figs. 7A-7D LEDs;
Figs. 9A-9C respectively represents a spatial distribution in intensity of light emission of an epitaxial light emission structure and that in intensity of fluorescence of a substrate in an LED of the present invention in a second embodiment;
Figs. 10A and 10B are cross sections of LEDs of the present invention in a third embodiment; and
Figs. 11A and 11B each represent a spatial distribution in intensity of light emission of an epitaxial light emission structure and that in intensity of fluorescence of a substrate in the third embodiment.

### DESCRIPTION OF THE PREFERRED EMBODIMENTS

Hereinafter the present invention in embodiments will be described.

The present invention is applied to a light emission apparatus having a surface-mounted LED in a typical LED mounting system allowing an epitaxial light emission structure to face upward, or fixing a substrate to a base having an electrode and serving as a device frame, and it is importantly characterized in that the LED is surrounded by an optical reflector to reflect fluorescence provided from the ZnSe substrate in particular so as to provide a corrected spatial distribution in intensity of light emission.

The present invention is applied to a bare chip of a multi-color LED having a substrate emitting light. As shown in Fig. 2, this bare chip provides a difference in a spatial distribution or directivity of light emission (E) between of the epitaxial light emission structure and of fluorescent light emission (S) from the substrate.

This is attributed to the fact that the light emission from the epitaxial layer, as well as a typical LED, is that from a significantly thin layer of an outermost surface of the bare chip, whereas the fluorescence from the substrate is light emission from the entire chip, i.e., there is a difference in position between the former light emission and the latter light emission.

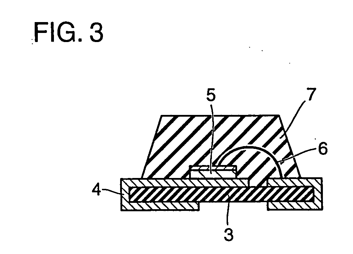

With this difference in directivity, if a typical, surface-mounted LED mounting method, or molding, is employed, e.g., as shown in Fig. 3, an LED (or chip) 5 mounted on a resin base 3 having a patterned interconnection 4 is sealed with transparent resin 7, then the mounted LED 5 provides light emission having a spatial distribution in intensity similar to that of the bare chip. Thus, when seen in different orientations, the two light emissions are mixed at different ratios and color tone cannot spatially be uniform.

Accordingly it is necessary to control these by such an improvement as described hereinafter to emit light having a uniform spatial distribution in color.

More specifically, of two types of light emitted from LED 5, fluorescence emitted from ZnSe substrate 1 in particular has its spatial distribution in intensity changed by a reflector external to LED 5 to be close to that in intensity of light emission from epitaxial light emission structure 2.

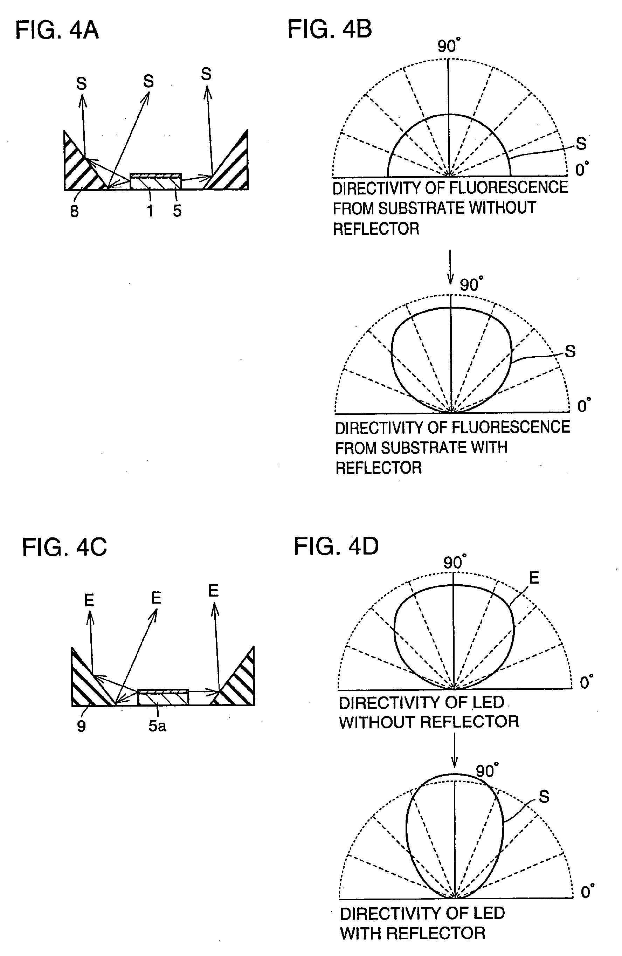

More specifically, as shown in Fig. 4A, fluorescence from ZnSe substrate 1 that radiates to a direction parallel to a surface on which LED 5 is mounted is reflected by a reflector 8 formed on resin base 3 to allow the light to radiate to a direction perpendicular to the surface having LED 5 mounted thereon.

Thus, as shown in Fig. 4B, the spatial distribution in intensity of fluorescence of ZnSe substrate 1 can be changed to be biased in a direction perpendicular to the surface having LED 5 mounted thereon. As shown in Fig. 2, the spatial distribution of light emission of epitaxial light emission structure 2 is originally biased in a direction perpendicular to the surface having LED 5 mounted thereon, and the spatial distribution in intensity of fluorescence of ZnSe substrate 1 can thus be matched to that in intensity of light emission of epitaxial light emission structure 2.

Possible reflector 8 in effect used is that having an arc-shaped surface, a parabolic-shaped surface or the like, or a flat surface or the like. Furthermore, possible such surfaces include a mirror-finished surface, a rough surface introducing diffusion, or the like. With its positional relationship with LED 5 taking into consideration, the Fig. 4A structure is readily be designed.

Reflector 8 can be formed of a highly reflective metal (e.g., a gold-plated copper plate), white resin (e.g., liquid crystal polymer-based resin), resin having a light scattering medium (e.g., titania, silica) distributed to provide an increased optical reflectance, resin having a surface covered with film of metal, or the like.

These can be provided readily as a reflective feature on a printed circuit board, a lead frame and the like that is normally used when a surface-mounted LED is fabricated.

Surface-mounted LED 5 having reflector 8 is similar in geometry to a so-called reflector-type package in a package of a typical, monocolor LED using GaP or the like.

It should be noted, however, that typical reflector-type packages are contemplated mainly to change light emission in directivity to collect light emitted by LED 5 and thus increase the luminosity of LED 5 in an exactly upward direction.

Figs. 4C and 4D show an exemplary structure of the aforementioned reflector-type package. As shown in the figure, a reflector 9 had been intended to increase luminosity. More specifically it had been intended to reflect upwards the light radiating in a direction parallel to a surface having LED 5a mounted thereon.

Accordingly, reflector 9 adopted had often been that significantly inclined in angle, a paraboloid capable of collimating light received from a point source of light, or the like.

The present invention is distinguished therefrom and contemplates generally matching the spatial distributions in intensity of two light emissions different in directivity, as described above, to emit uniform, mixed-color light. Accordingly, reflector 8 for mixing colors has an optimal structure different from that of typical reflector 9.

As will be described in the embodiments described hereinafter, color mixing reflector 8 has a reflecting surface, as optimized in structure, including for example an arc reflecting plane, a flat reflecting plane forming an angle of 40° to 90° with a plane having LED 5 mounted thereon, and the like. Furthermore, the reflector is widely ranged from a metallic reflecting surface having a reflectance exceeding 90% to a tinted resin surface having a reflectance of only approximately 10%.

Furthermore LED 5 of the present invention is characterized in changing the ratio in intensity between light emission from epitaxial light emission structure 2 and fluorescence from ZnSe substrate 1 to adjust the color of the mixture thereof, i.e., the color of light emitted by the LED.

For example, if epitaxial light emission structure 2 is a structure having a sharp light emission peak at 485 nm and the substrate is ZnSe 1 doped with iodine (I), then the substrate's fluorescence would be light emission having a broad peak with 585 nm.

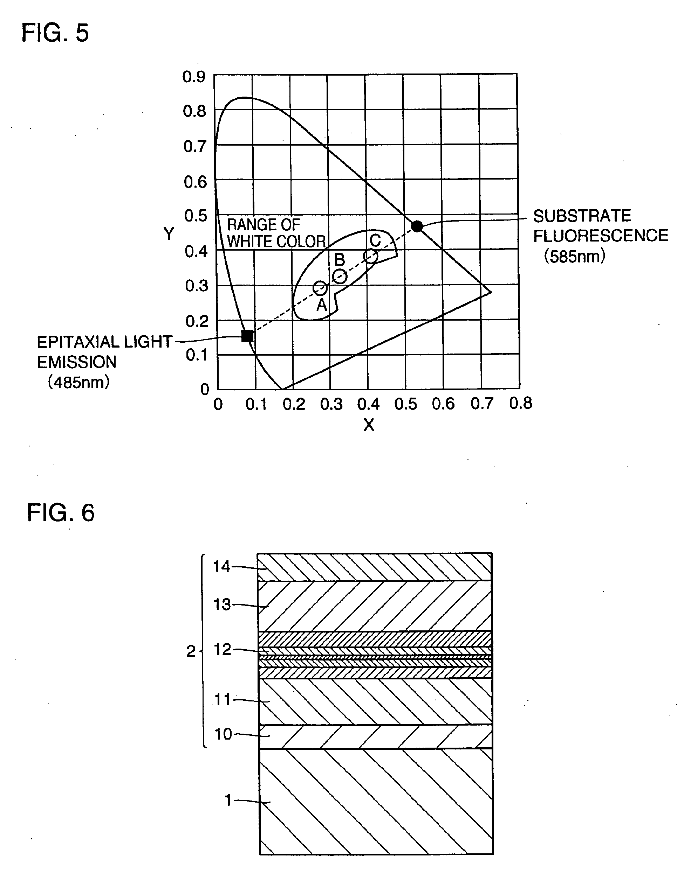

The colors of the light emissions of the both are represented by chromaticity coordinates (x, y), as shown in Fig. 5. Epitaxial light emission structure 2 provides light emission (blue light emission) indicated by a black square and ZnSe substrate 1 allows fluorescence (yellow light emission) indicated by a black circle and the colors that are mixed together are represented by a point on a line connecting the two points.

If the blue light emission from epitaxial light emission structure 2 is larger in proportion then a bluish white color, i.e., a cold white color would be provided, as represented by a point A,. If the yellow fluorescence from ZnSe substrate 1 is larger in proportion then a yellowish white color, i.e., a warm white color would be provided, as represented by a point C. Furthermore, if their levels of intensity are balanced at a ratio then pure white color would be provided, as represented by a point B.

By changing ZnSe substrate 1 in thickness or doping the substrate with dopant of different concentrations and species, fluorescence can emitted with different levels of intensity. These techniques allow a mixture of colors to be adjusted in color to obtain light emission having a variety of color tones.

Emission of fluorescence of ZnSe substrate 1 can be adjusted in intensity not only by changing the original luminosity of the substrate, as described above, but also changing the efficiency in externally extracting the fluorescence of the substrate. The latter technique can also be as effective as described above.

In the present invention if reflector 8 varies in optical reflectance then fluorescence from ZnSe substrate 1 varies in intensity, as seen in a direction in which it radiates. The LED 5 light emission can thus be adjusted in color.

Using reflector 8 having a low optical reflectance (e.g., brown resin) results in a reduced amount of the fluorescence of ZnSe substrate 1 that is reflected in a direction perpendicular to a surface having LED 5 mounted thereon. This can implement a color tone with epitaxial light emission larger in proportion. (For an LED for white color, a bluish white color can be provided.)

By contrast, using reflector 8 having a high optical reflectance (e.g., resin covered with film of metal) results in fluorescence of ZnSe substrate 1 having a large portion reflected in a direction perpendicular to the surface having LED 5 mounted thereon. This can implement a color tone with the substrate's fluorescence larger in proportion (For an LED for white color, a yellowish white color can be provided.).

If the substrate's fluorescence and the epitaxial light emission can be well balanced in intensity, a color tone as desired (e.g., pure white color) can be implemented and the resultant mixture of light emitted can also have a spatially uniform distribution.

In the present invention, LED 5 does not have any difference from a conventional, surface-mounted LED chip in geometry and how it is fabricated, and it is not necessary to adopt a mounting structure having an epitaxial layer facing downward, an embedded structure, or the like. As such, an already established, inexpensive technique of fabricating a surface-mounted LED can exactly be applied in the present invention.

Thus there can be implemented at low cost a surface-mounted LED which emits light in any direction in a uniform tone, allows emitted light to appear to have a single tone in whichever direction it may be seen, and provides light of white, and magenta, pink and other similar neutral colors in a variety of color tones

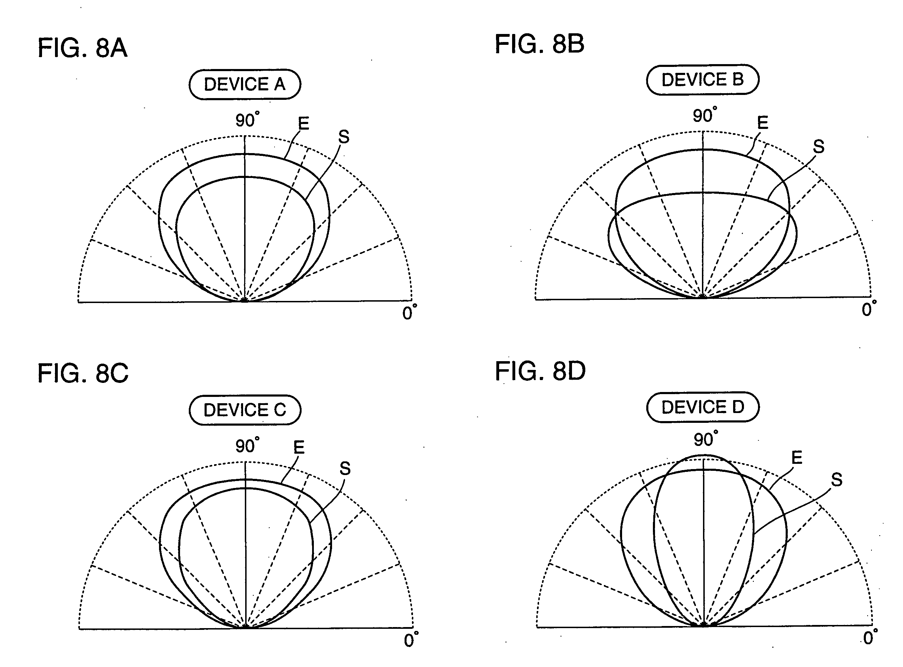

Hereinafter the present invention in embodiments will be described with reference to Figs. 6-11B.

### First Embodiment

On an iodine-doped, n-type ZnSe substrate 1, an epitaxial light emission structure 2, as shown in Fig. 6, for blue color having a peaked emission wavelength of 485 nm is grown by homoepitaxy with an MBE method.

Epitaxial light emission structure 2 is composed of a p-type contact layer 14 having a superlattice structure of a stack of layers of ZnTe and , ZnSe doped to be p-type, a p-type clad layer 13 formed of a layer of Zn_{0.85}Mg_{0.15}S_{0.10}Se_{0.90} doped to be p-type, a single quantum well active layer 12 formed of a structure of a stack of layers of a ZnSe layer and a Zn_{0.88}Cd_{0.12}Se layer, an n-type clad layer 11 formed of a Zn_{0.85}Mg_{0.15}S_{0.10}Se_{0.90} layer doped to be n type, and an n-type ZnSe buffer layer 10.

On p-type contact layer of an epitaxial wafer, there is formed a patterned, p-type electrode formed of Ti/Au in a lattice, and there is further formed a full-surface covered Au electrode in a thin film of no more than 20 nm in thickness, and on the substrate at a back surface thereof an n-type electrode formed of In is provided.

After the electrode is formed, the epitaxial wafer is cut to be a chip (of type 1) sized to be 400 µm x 400 µm and having a thickness of 200 µm. Furthermore, exactly the same procedure is used to form on an Al-doped ZnSe substrate 1 a structure for blue color having a peaked emission wavelength of 475 nm and cut the resultant product in the form of a chip.

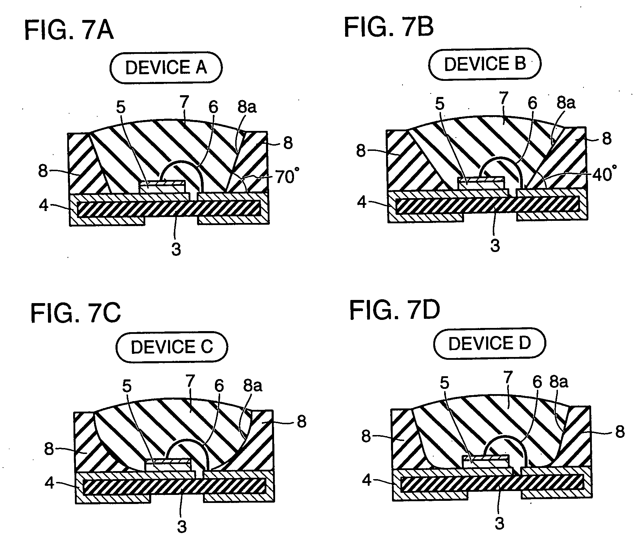

These chips are mounted on resin base 3 to fabricate four types of surface-mounted LED 5, as shown in Figs. 7A-7D.

A device A is a simple, flat reflector 8, with a reflecting surface 8a and a surface having LED 5 mounted thereon together forming an angle of 70°. A device B is a similarly flat reflector 8, with reflecting surface 8a and the surface having LED 5 mounted thereon together forming an angle of 40°. A device C is a reflector 8 having an arc, reflecting surface 8a having a center at the position of an opening located exactly above LED 5. A device D is reflector 8 having a parabolic reflecting plane 8a with a focus corresponding to the position at which LED 5 is mounted.

Reflector 8 has an opening with an upper end sized to be 1.2 mm and a height of 0.8 mm. Furthermore in the present embodiment on the side of a surface having LED 5 mounted thereon reflector 8 has an opening shaped to be a square.

Reflector 8 is formed of a white, liquid crystal polymer-based resin, and a base with an electrode is a printed circuit board (resin base 3) formed of BT resin with a patterned interconnection 4 of a structure of a stack of layers Cu/Ni/Au provided thereto. The printed circuit board and reflector 8 are stuck together with adhesive to fabricate LED 5. Since it is a surface-mounted device, patterned interconnection 4 extends to a back surface of the device (or a back surface of the printed circuit board).

It can have the same effect if for the color mixing reflector and the base with the electrode, white resin is insert-molded and thus formed in a reflector on a lead frame for example of copper- or iron-based metal. Furthermore in the present embodiment reflector 8 has an opening sealed with transparent resin (epoxy resin) 7.

Initially, surface-mounted LED 5 of type 1 was estimated. An electric current was introduced to allow epitaxial light emission structure 2 to emit light. Epitaxial light emission structure 2 provided blue light emission having a peak of 485 nm and furthermore the blue light emission was partially absorbed by ZnSe substrate 1 and through fluorescence the substrate emitted yellow fluorescence having a peak of 585 nm.

The blue light emission and the yellow fluorescence are specially distributed, as shown in Figs, 8A-8D for devices A-D, respectively.

As shown in Fig. 2, in the bare chip's spatial light emission distribution in intensity there is a significant difference between a directivity of blue light emission from epitaxial light emission structure 2 and that of fluorescence from ZnSe substrate 1, whereas for the device with color mixing reflector 8, as provided in the present embodiment, the directivities approaches to be similar to each other.

This is because reflector 8 reflects the substrate's fluorescence that radiates in a direction parallel to a surface having LED 5 mounted thereon and thus redirects it to radiate in a direction perpendicular to the surface having LED 5 mounted thereon, to allow fluorescence to significantly vary in directivity.

The light emission from the epitaxial structure 2 inherently does not have a high intensity in the direction of reflector 8, and thus the spatial distribution is not significantly changed. In particular for devices A and C the spatial distribution in intensity of light from epitaxial structure 2 and that in intensity of light from substrate 1 substantially match and as a result there has been obtained LED 5 allowing a constant color tone in whichever direction it is observed.

These devices provided light emission of yellowish, warm white color (of approximately 4000K in (correlated color temperature). Of these four types of color mixing reflector 8, device D of parabolic type is most inferior in that the epitaxial structure 2 light emission and the substrate's fluorescence least match in directivity, and the problem of mottling is not completely resolved, although the device is brightest in terms of the intensity in an exactly upward direction.

As well as surface-mounted LED 5 of type 1, that of type 2 also received an electric current and epitaxial light emission structure 2 was thus allowed to emit light. It provided blue light emission having a peak of 475 nm and further more this blue light emission was partially absorbed by ZnSe substrate 1 and thus through fluorescence the substrate emitted Mars yellow fluorescence having a peak of 610 nm.

These devices' spatial light emission distributions in intensity were examined and as well as that of type 1 device A has been found to allow the blue light emission from epitaxial light emission structure 2 and the Mars yellow light emission from ZnSe substrate 1 to best match in directivity and it was able to provide a light emitting device providing a uniform color tone in whichever azimuth the light is observed. The device emitted magenta light.

Note that while in the present embodiment, as has been described above, color mixing reflector 8 has an opening shaped to be a square, the present invention is similarly effective if reflector 8 has an opening shaped for example in a circle or a rectangle. Furthermore, if the opening is square, rectangular or the like, then a reflector with a pair of color mixing reflectors 8 having a geometry as seen in a direction and that of color mixing reflectors 8 having a different geometry as seen in a direction perpendicular thereto (e.g., a color mixing reflector having a cross section of device A in a direction and a cross section of device B in a direction perpendicular thereto) can also function as an effective color mixing reflector 8.

### Second Embodiment

The present invention in a second embodiment will now be described. In the present embodiment a chip similar to the chip of type 1 used in the first embodiment was prepared. The chip was also mounted in a structure having a reflector having the geometry of device A used in the first embodiment. It should be noted, however, that herein reflector 8 is formed of different material and has a surface in a different condition than the first embodiment.

More specifically, for a device E a reflector is formed of opaque resin containing titania diffused therein, for a device F a smooth surface of resin plated with gold to provide a mirror finished surface is employed for reflector 8, and for a device G a surface of resin having small protrusions and depressions and plated with silver to be moderately glossy is used for reflector 8. They are mounted, as has been described in the first embodiment.

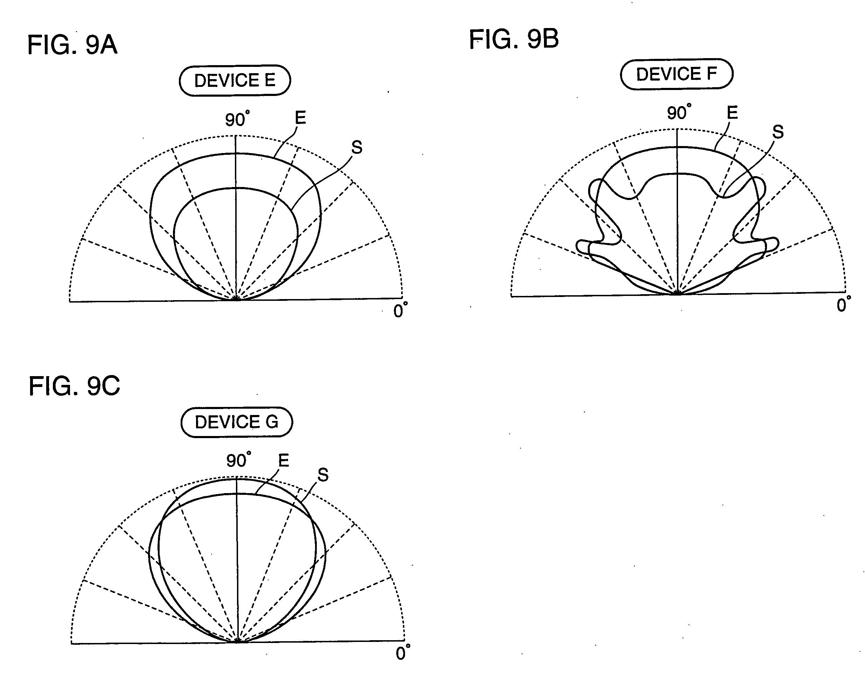

LED 5 fabricated in the present embodiment provides a distribution of in intensity blue light emission from epitaxial light emission structure 2 and that in intensity of yellow fluorescence from ZnSe substrate 1, as represented in Figs. 9A-9C. As well as in the first embodiment, devices E and G allowed the blue light emission and the yellow fluorescence to substantially match in directivity and were thus able to provide LED 5 emitting light spatially uniform in color.

Furthermore, as can be seen from Figs. 9A-9C, device G allows the substrate providing fluorescence radiated with a grater intensity than device E and this means that reflector 8 plated with gold has a higher reflectance. Consequently, device G provided white color more yellowish in color tone than device E. It should be noted that device E provided a correlated color temperature of 4500K and device G provided that of 3700K.

In device F, by contrast, the substrate provides fluorescence having a spatial profile having protrusions. This is because reflector 8 has reflecting surface 8a mirror finished and there thus appeared a directivity reflecting a light emission point of LED 5.

It can thus be understood that to obtain a spatially uniform light emission distribution in intensity, reflector 8 preferably has reflecting surface 8a roughened (or having protrusions and depressions) to introduce diffusion.

### Third Embodiment

The present invention in a third embodiment will now be described. In the present embodiment, chips of types 1 and 2 identical to those used in the first embodiment were prepared. The chip was mounted in a structure having a reflector similar in geometry to device A used in the first embodiment, although herein reflector 8 was formed of a different material and had a different geometry.

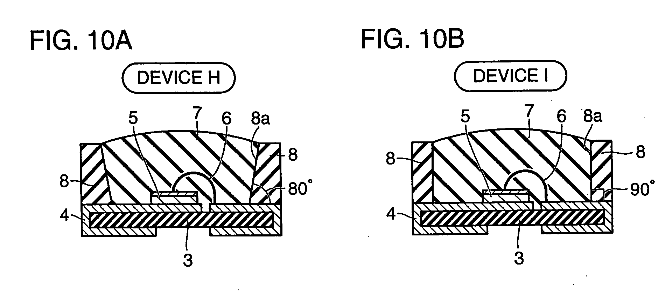

As shown in Figs. 10A and 10B, for a device H a reflector is formed of a less reflective, yellow, liquid crystal polymer-based resin and the reflector, with reflecting surface 8a and an LED 5 mounted surface forming an angle of 80°, and for a device I a reflector is formed of a less reflective, brown, liquid crystal polymer-based resin and reflector 8 and an LED 5 mounted surface form an angle of 90°. They were mounted, as has been described in the first embodiment.

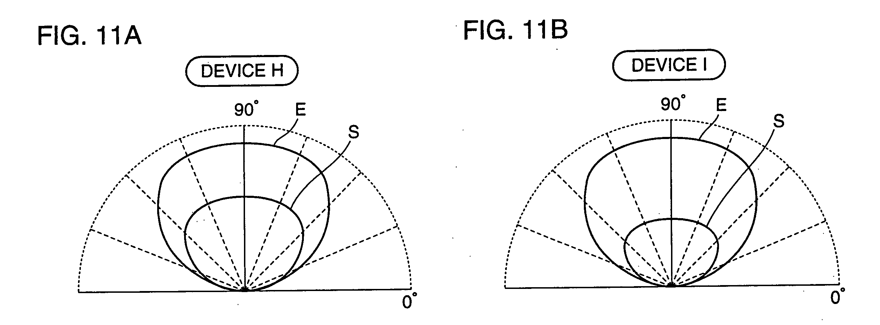

LED 5 fabricated in the present embodiment provided a spatial emission distribution in intensity of blue light emission from epitaxial light emission structure 2 and that in intensity of yellow fluorescence from ZnSe substrate 1, as shown in Figs. 11A and 11B.

As well as for example device A of the first embodiment, devices H and I both allow the blue light emission and the yellow fluorescence to substantially match in directivity and were able to provide LED 5 emitting light spatially uniform in color. Furthermore, as can be understood from Figs. 11A and 11B, in either device the substrate provides fluorescence radiated with a smaller intensity than for example in device A of the first embodiment and device E of the second embodiment. This is attributed to the fact that reflector 8 is smaller in reflectance than the material described above.

Consequently, device H with the chip of type 1 mounted therein provided substantially pure white color and device I with the chip of type 1 mounted therein provided white color bluish in color tone. Note that device H provided a correlated color temperature of 6000K and device I provided that of 10000K. Furthermore, device H with the chip of type 2 mounted thereon and device I with the chip of type 2 mounted therein were able to emit light of pink color and that of violet color, respectively, both uniform spatially.

In the present invention a reflector can be provided and a spatial distribution in intensity of fluorescence from a substrate can thus approximate to that in intensity of light emission from an epitaxial light emission structure. Thus there can be provided a light emitting device emitting light in any direction in a uniform color tone and allowing light emission to appear to have a single color tone in whichever direction the light may be observed. Furthermore, the substrate having the epitaxial light emission structure can be mounted on a base having an electrode and an already established, inexpensive surface-mounted LED fabrication technology can thus be applied as it is. Thus an inexpensive and simple process can be used to fabricate the light emitting device.

Thus a light emitting device providing white, magenta, pink and other similar neutral colors in various color tones that emit light having a spatially uniform distribution in color can inexpensively and readily be fabricated and is expected to be significantly demanded for applications such as displaying in mobile gear, liquid crystal display's backlight, decoration and the like in particular.

Although the present invention has been described and illustrated in detail, it is clearly understood that the same is by way of illustration and example only and is not to be taken by way of limitation, the spirit and scope of the present invention being limited only by the terms of the appended claims.

## Claims

1. A light emitting device comprising:
a base (3) having an electrode (4);
a substrate (1) formed of n-type ZnSe single crystal and mounted on said base;
an epitaxial light emission structure (2) formed of a compound crystal relating ZnSe serving as a matrix thereof, said epitaxial light emission structure being provided on said substrate and emitting light when an electric current introduced thereinto; and
a reflector (1) matching a spatial distribution in intensity of light emission from said epitaxial light emission structure to a spatial distribution in intensity of fluorescence obtained in said substrate excited with the light emission from said epitaxial light emission structure.

2. The light emitting device of claim 1, wherein said reflector scatters said fluorescence from said substrate in a direction of light emitted by said light emitting device.

3. The light emitting device of claim 1, wherein said reflector is provided on said base located around said substrate.

4. The light emitting device of claim 1, wherein said reflector has an optical reflectance varying to adjust a ratio in intensity between said light emission from the said epitaxial light emission structure and said fluorescence from said substrate.

5. The light emitting device of claim 1, wherein:
said reflector includes resin of white color, resin having a light scattering medium buried therein, or resin having a surface covered with film of metal; and
said base includes a printed circuit board formed of resin and having a patterned interconnection (4).

6. The light emitting device of claim 1, emitting light of white color ranging from yellowish white color through bluish white color, or a neutral color including magenta, pink and the like.
